# EUROPEAN PATENT APPLICATION

(11) **EP 1 143 685 A1**
(43) Date of publication of application: **10.10.2001**
(21) Application number: 00971800.8
(22) Date of filing: 06.11.2000
(51) Int. Cl.: H04L 29/08, H04B 7/26, H04M 1/00

(54) **METHOD AND APPARATUS FOR DATA TRANSMISSION**

(30) Priority: 05.11.1999 JP 31588699
(71) Applicant: Sony Corporation, Tokyo 141-0001 (JP)
(72) Inventor: NAGASE, Taku, Sony Corporation, Shinagawa-ku, Tokyo 141-0001 (JP); TERASHIMA, Kazuhiko ,Sony Corporation, Shinagawa-ku, Tokyo 141-0001 (JP)
(74) Representative: Melzer, Wolfgang, Dipl.-Ing.
(86) International application number: JP0007786
(87) International publication number: WO0133810

(57) **Abstract**

A portable wireless data transmitter (1) such as portable telephone or the like includes a battery voltage monitoring circuit (7) which detects the voltage of a battery used as a voltage source for the transmitter (1), and a status judging unit (8) supplied with the detected voltage value from the battery voltage monitoring circuit (7) to produce a control signal with which the operations for data transmission are controlled. Thus, the data transmitter (1) can be operated for an increased length of time with minimum change in status of communications due to a temperature-caused degradation of the battery characteristic.

## Description

### Technical Field

The present invention relates to a portable wireless data transmitter, and a method for wireless data transmission.

### Background Art

Recently, the portable data transmitters capable of data transmission and reception by wireless communications have been developed actively. Among others, the portable terminals or portable remote terminal used in the portable telephone system and personal handyphone system (PHS) have rapidly become popular. It is generally said that since the portable remote terminal comprises a lithium-ion secondary battery capable of heavy-load discharging and repeated use with recharging, so it can be operated for a long time.

When the power of the battery has been consumed to such an extent that the remaining potential of the battery is not sufficient for data transmission, the conventional transmitters, especially, portable remote terminals, will suddenly become disabled for any communications. Generally, portable remote terminals determine a data transmission bit rate correspondingly to an amount of data to be transmitted and a status in which it exists, and transmits data on transmission power corresponding to the determined data transmission bit rate. Namely, portable remote terminals suddenly become disabled for data transmission as in the above because they try to transmit data on that transmission power irrespective of the power insufficiency due to the battery power consumption.

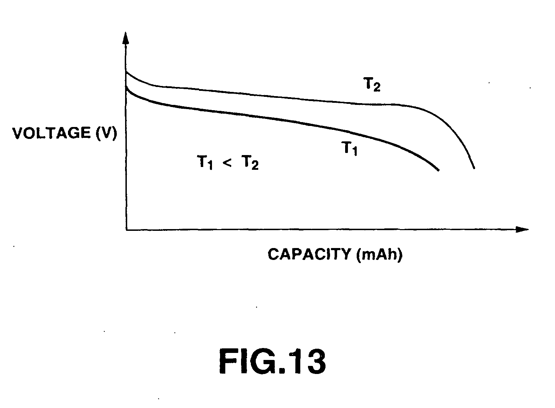

Also, the lithium-ion secondary battery used as a power source in portable remote terminals has an internal resistance thereof varied as ambient temperature changes. As shown in FIG. 13, if the ambient temperature is low, for example, when the PDA is used, the internal resistance of the lithium-ion secondary battery will be raised and thus inhibit the secondary battery, which has still a sufficient potential for the data transmission, from providing the PDA with a necessary transmission power as if the battery power had been consumed as in the above. The conventional portable remote terminal is not advantageous in that when the ambient temperature is low, it cannot operate with a high quality of communications or it may be disabled for communications.

### Disclosure of the Invention

Accordingly, the present invention has an object to overcomes the above-mentioned drawbacks of the prior art by providing a data transmitting apparatus and method, capable of data transmission for an increased length of time with minimum change in status of communications due to a temperature-caused degradation of the battery characteristic.

The above object can be attained by providing a portable wireless data transmitter including, according to the present invention, data transmission processing controlling means for controlling a transmission rate for data which is going to be transmitted, battery voltage detecting means for detecting voltage of a battery which supplies a drive voltage, and a transmission status judging means for controlling the data transmission process controlling means correspondingly to a detected voltage supplied from the battery voltage detecting means.

In the above data transmitter, the voltage of the battery which supplies the drive voltage is detected by the battery voltage detecting means and the data transmission rate controlling means is controlled by the transmission status judging means to control the data transmission rate.

Also the above object can be attained by providing a portable wireless data transmitter including, according to the present invention, a data encoding means, battery voltage detecting means for detecting voltage of a battery which supplies a drive voltage, and a transmission status judging means for controlling the data encoding means correspondingly to a detected voltage supplied from the battery voltage detecting means.

In the above data transmitter, the voltage of the battery which supplies the drive voltage is detected by the battery voltage detecting means and the data transmission rate controlling means is controlled by the transmission status judging means to control the data encoding.

Also the above object can be attained by providing a method for wireless data transmission in which a source voltage is detected and data transmission is controlled correspondingly to the detected source voltage.

In the above data transmitting method, the data transmission is controlled correspondingly to the source voltage.

Also the above object can be attained by providing a method for wireless data transmission in which a source voltage is detected and data encoding is controlled correspondingly to the detected source voltage.

In the above data transmitting method, the data encoding is controlled correspondingly to the source voltage.

### Brief Description of the Drawings

FIG. 1 is a block diagram of a first embodiment of the data transmitter according to the present invention.
FIG. 2 is a flow chart of operations effected in the process in which the first embodiment of data transmitter is supplied with data and transmits it wirelessly.
FIG. 3 is a block diagram of a second embodiment of the data transmitter according to the present invention.
FIG. 4 is a flow chart of operations effected in the process in which the second embodiment of data transmitter is supplied with data and transmits it wirelessly.
FIG. 5 is a block diagram of a third embodiment of the data transmitter according to the present invention.
FIG. 6 is a flow chart of operations effected in the process in which the third embodiment of data transmitter is supplied with data and transmits it wirelessly.
FIG. 7 is a block diagram of a fourth embodiment of the data transmitter according to the present invention.
FIG. 8 is a flow chart of operations effected in the process in which the fourth embodiment of data transmitter is supplied with data and transmits it wirelessly.
FIG. 9 is a block diagram of a fifth embodiment of the data transmitter according to the present invention.
FIG. 10 is a flow chart of operations effected in the process in which the fifth embodiment of data transmitter is supplied with data and transmits it wirelessly.
FIG. 11 is a block diagram of a sixth embodiment of the data transmitter according to the present invention.
FIG. 12 is a flow chart of operations effected in the process in which the sixth embodiment of data transmitter is supplied with data and transmits it wirelessly.
FIG. 13 shows a relation between the operating temperature and internal resistance of the lithium-ion secondary battery.

### Best Mode for Carrying Out the Invention

The embodiments of the present invention will described in detail below with reference to the accompanying drawings.

The data transmitter according to the present invention is adapted to control the data transmission or data encoding correspondingly to a detected source voltage. The data transmitter is, for example, a portable remote terminal such as a cellular phone and makes wireless transmission and reception of data. Note however that the data transmitter according to the present invention will be described below concerning only the transmission system thereof and the reception system will not be described.

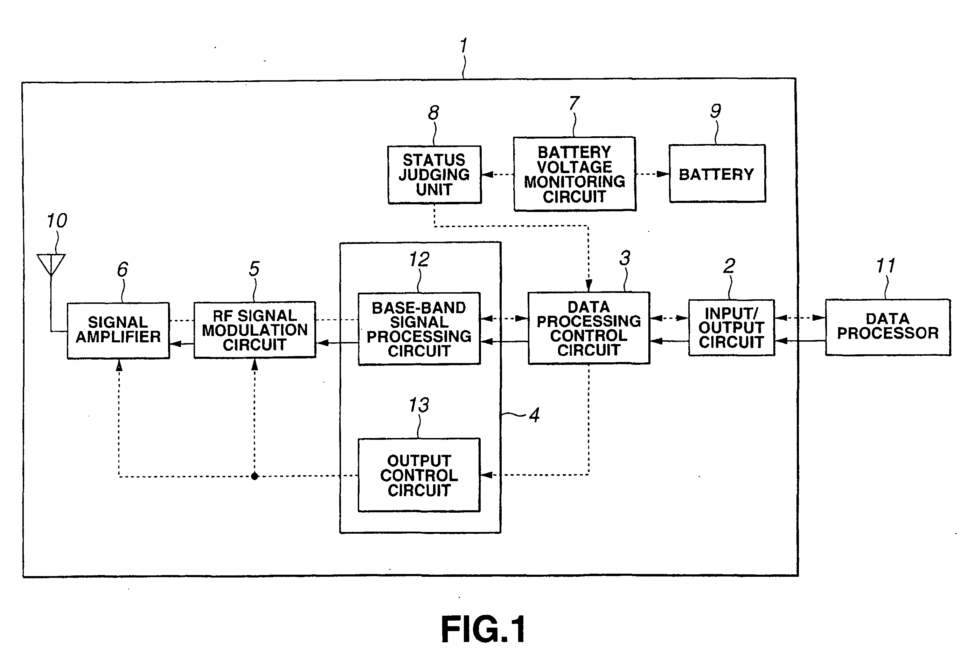

Referring now to FIG. 1, there is schematically illustrated in the form of a block diagram the first embodiment of the data transmitter according to the present invention. Note that the solid lines in FIG. 1 indicate the flow of data while the broken lines indicate the flow of control signal.

In FIG. 1, the data transmitter is generally indicated with a reference 1. The data transmitter 1 includes an input/output circuit 2, a data processing control circuit 3, a baseband signal processor 4, an RF signal modulation circuit 5, a signal amplifier 6, a battery voltage monitoring circuit 7, a status judging unit 8, a battery 9 and an antenna 10.

The input/output circuit 2 is supplied with a control signal from the data processing control circuit 3 and provides it to an external data processor 11 such as a personal computer (PC) for example. Also the input/output circuit 2 is supplied with packetized data from the data processor 11 and provides it to the data processing control circuit 3. Note that the data processor 11 may be provided inside the data transmitter 1 such as a portable remote terminal.

The data processing control circuit 3 has provided therein a memory which stores packetized data, and controls the flow and retransmission of the packetized data while determining a data transmission bit rate on the basis of an upper limit of the data transmission bit rate, supplied from the status judging unit 8 which will further be described later. The data processing control circuit 3 functions as will be described below:

The data processing control circuit 3 monitors the status of the internal memory thereof. When the memory becomes empty, the data processing control circuit 3 will request, via the input/output circuit 2, the data processor 11 for sending new packetized data. When the memory is filled with packetized data, the data processing control circuit 3 will provide packetized data to a baseband signal processing circuit 12. If the data processing control circuit 3 fails to send the packetized data, it will retransmit the same packetized data to the baseband signal processing circuit 12. When the data processing control circuit 3 succeeds in sending the packetized data, it will request, via the input/output circuit 2, the data processor 11 for sending new packetized data, and store, into the internal memory thereof, the new packetized data received from the data processor 11.

Also, the data processing control circuit 3 will change control data related to the data transmission bit rate designated to the baseband signal processing circuit 12 according to a time for which the internal memory is empty. That is, when the amount of data supply from the input/output circuit 2 is small and the time for which the internal memory is empty is long, the data processing control circuit 3 will lower the data transmission bit rate. On the contrary, when the amount of data supply from the input/output circuit 2 is large and the time for which the internal memory is empty is short, the data processing control circuit 3 will raise the data transmission bit rate within a range not higher than an upper limit of the data transmission bit rate, supplied from the status judging unit 8.

The baseband signal processor 4 includes a baseband signal processing circuit 12 and an output control circuit 13. The baseband signal processing circuit 12 produces a baseband signal from the data supplied from the data processing control circuit 3, and supplies it to the RF signal modulation circuit 5.

The output control circuit 13 is supplied data concerning the data transmission bit rate for each packetized data, supplied from the data processing control circuit 3, and supplies the RF signal modulation circuit 5 and signal amplifier 6 with a signal for changing the status of data processing according to a transmission bit rate for data to be transmitted (will be referred to as "transmission data" hereunder). For example, when the transmission bit rate for transmission data is larger than a threshold, the output control circuit 13 will supply the signal amplifier 6 with a signal for changing the output power according to the transmission bot rate for the transmission data. More particularly, when the transmission bit rate for transmission data has been raised, the output control circuit 13 will supply the signal amplifier 6 with a signal which increases the output power. On the contrary, when the transmission bit rate for the transmission data has been lowered, the output control circuit 13 will supply the signal amplifier 6 with a signal which decreases the output power. When the data transmission bit rate for data to be transmitted from the data processing control circuit 3 is lower than a threshold, the output control circuit 13 will provide a signal which shifts the signal amplifier 6 to a power-saving status in which the signal amplifier 6 will be bypassed or supplied with no power.

The RF signal modulation circuit 5 modulates a baseband signal supplied from the baseband signal processing circuit 12 to produce an RF (radio frequency) signal for transmission on a carrier wave. The RF signal modulation circuit 5 supplies an RF signal to the signal amplifier 6.

Also, the RF signal modulation circuit 5 is supplied, from the output control circuit 13, with a signal for changing the status of modulation of the baseband signal to an RF signal, and it will modulate the baseband signal to RF signal according to the signal.

The signal amplifier 6 amplifies the RF signal supplied from the RF signal modulation circuit 5. Also, the signal amplifier 6 is supplied, from the output control circuit 13, with a signal for changing the status of amplification of the RF signal. The signal amplifier 6 carries out an amplification according to the signal. The amplified RF signal is wirelessly transmitted to outside via the antenna 10.

The battery voltage monitoring circuit 7 detects the voltage of the battery 9 being a drive voltage source for the data transmitter 1, and converts the battery voltage to an electric signal which will be supplied to the status judging unit 8.

The status judging unit 8 compares the voltage of the battery 9, supplied from the battery voltage monitoring circuit 7, with a pre-stored target voltage value, and determines an upper limit of the transmission bit rate for a transmission data. Namely, when the battery voltage supplied from the battery voltage monitoring circuit 7 is lower than the target voltage value, the status judging unit 8 will lower the upper limit for the data transmission bit rate. On the contrary, when the battery voltage supplied from the battery voltage monitoring circuit 7 is higher than the target voltage value, the status judging unit 8 will raise the upper limit for the data transmission bit rate. Thus, the status judging unit 8 supplies a signal indicative of the determined upper limit to the data processing control circuit 3. However, the status judging unit 8 has set therein a maximum upper limit which will not shorten the service hour of the battery 9 even if the upper limit of the transmission bit rate is thus raised.

Generally, in case of a data transmission based on the CDMA (code division multiple access) method, when the data is transmitted at a half of the transmission bit rate for example, the energy per unit bit will be double, so the error rate will be the same even with a half of the transmission power. Therefore, the lower the transmission bit rate, the smaller the necessary transmission power for the same error rate will be.

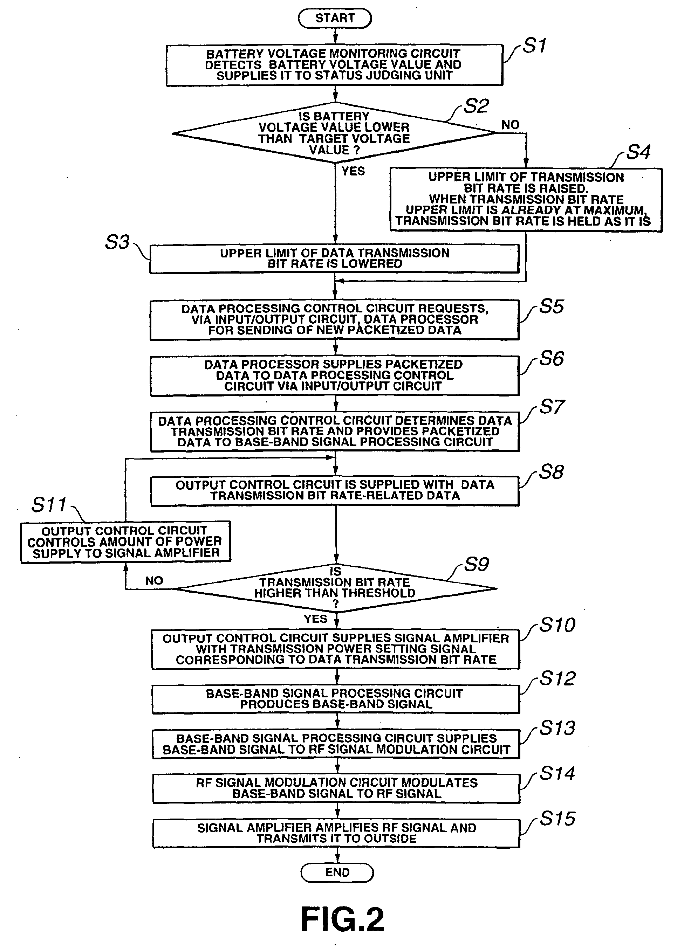

In the data transmitter 1 constructed as having been described in the foregoing, data supplied from the data processor 11 will be transmitted wirelessly through a series of steps as shown in the flow chart in FIG. 2.

First at step S1 shown in FIG. 2, the battery voltage monitoring circuit 7 detects a source voltage of the battery 9, converts it to an electric signal, and supplies it to the status judging unit 8.

At step S2, the status judging unit 8 judges whether a voltage value indicated by the electric signal supplied from the battery voltage monitoring circuit 7 is lower than a pre-stored target voltage value. If the voltage value indicated by the electric signal is judged to be lower than the target voltage value, the status judging unit 8 goes to step S3 where it will lower the upper limit of the data transmission bit rate and inform the data processing control circuit 3 of the lowered upper limit. On the contrary, if the voltage value indicated by the electric signal is judged to be higher than the target voltage value, the status judging unit 8 goes to step S4 where it will raise the upper limit of the data transmission bit rate and inform the data processing control circuit 3 of the raised upper limit. At this time, if the upper limit of the transmission bit rate is already at the maximum, the transmission bit rate is held unchanged.

At step S5, the data processing control circuit 3 requests, via the input/output circuit 2; the data processor 11 for sending a new packetized data.

At step S6, the data processor 11 provides a packetized data to the data processing control circuit 3 via the input/output circuit 2.

At step S7, the data processing control circuit 3 determines a data transmission bit rate, informs the baseband signal processing circuit 12 of the determined data transmission bit rate, and provides the packetized data to the baseband signal processing circuit 12.

Next at step S8, the output control circuit 13 is supplied with a signal indicative of the data transmission bit rate supplied from the data processing control circuit 3.

At step S9, the output control circuit 13 judges whether the data transmission bit rate indicated by the signal is higher or lower than a threshold. If the momentary transmission bit rate is judged as being higher than the threshold, the output control circuit 13 supplies, at step S10, the signal amplifier 6 with a signal for changing the output power correspondingly to the transmission bit rate for transmission data. On the contrary, if the transmission bit rate for data to be transmitted from the data processing control circuit 3 is lower than the threshold, the output control circuit 13 provides, at step S11, a signal which shifts the signal amplifier 6 to a power-saving status in which the signal amplifier 6 will be bypassed or supplied with no power.

Next at step S12, the baseband signal processing circuit 12 produces a baseband signal from the packetized data.

Next at step S13, the baseband signal processing circuit 12 supplies the RF signal modulation circuit 5 with the baseband signal produced from the data supplied from the data processing control circuit 3.

At step S14, the RF signal modulation circuit 5 modulates the baseband signal supplied from the baseband processing circuit 12 to produce an RF signal which will be transmitted on a carrier wave, and supplies it to the signal amplifier 6.

At step S15, the signal amplifier 6 amplifies the RF signal supplied from the RF signal modulation circuit 5, and wirelessly transmits the amplified RF signal via the antenna 10.

As in the foregoing, in the data transmitter 1, the upper limit of the transmission bit rate for the packetized data is controlled based on the detected source voltage of the battery 9 and a pre-set target voltage value. That is, in the data transmitter 1, when the remaining potential of the battery 9 is lower than a certain value, the upper limit of the data transmission bit rate is lowered to reduce the power consumption. Also, in the data transmitter 1, when the remaining potential of the battery 9 is lower, the power consumption can be reduced by lowering the transmission bit rate upper limit to prevent the data communications from suddenly being discontinued and the upper limit of the data transmission bit rate can be controlled correspondingly to the voltage of the battery 9 to prevent the quality of the data communications from becoming lower.

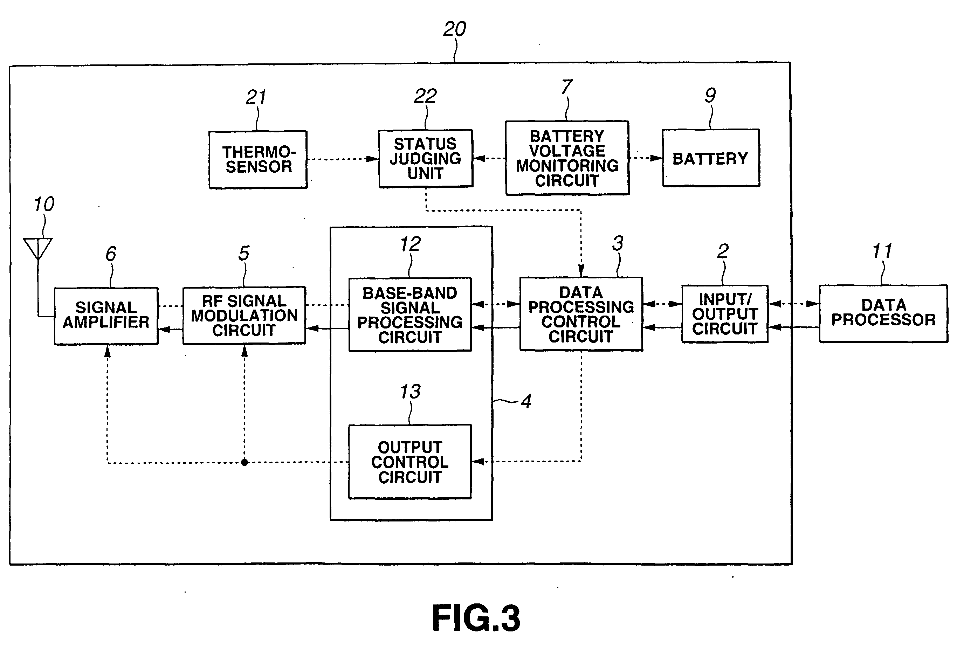

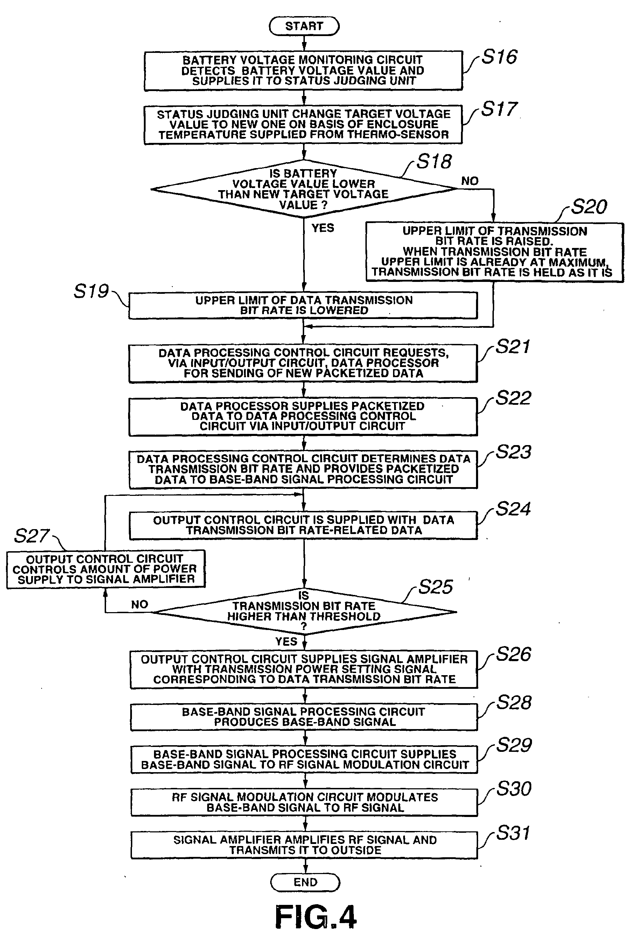

Next, the second embodiment of the data transmitter according to the present invention will be described with reference to FIGS. 3 and 4.

In FIG. 3, the second embodiment of the data transmitter is generally indicated with a reference 20. The data transmitter 20 is basically similar in construction to the data transmitter 1 according to the first embodiment of the present invention, having been described in the above with reference to FIG. 1, except that there is provided a thermo-sensor 21 to detect the temperature of an enclosure of the data transmitter 20. Therefore, the same or similar elements included in the data transmitter 20 as or to those in the data transmitter 1 are indicated in FIG. 2 with the same or similar references as or to those in FIG. 1, and will not be described in detail below. Note that the solid lines in FIG. 2 indicate the flow of data while the broken lines indicate the flow of control signal.

As shown in FIG. 3, the data transmitter 20 includes the input/output circuit 2, the data processing control circuit 3, the baseband signal processor 4, the RF signal modulation circuit 5, the signal amplifier 6, the battery voltage monitoring circuit 7, the battery 9, the antenna 10, a thermo-sensor 21 and a status judging unit 22.

The thermo-sensor 21 detects the enclosure temperature of the data transmitter 20, converts the detected enclosure temperature to an electric signal and supplies it to the status judging unit 22 which will further be described later. The enclosure temperature of the data transmitter 20 is a temperature of the body of the data transmitter 20, which changes under the influence of the ambient temperature. For example, when the data transmitter 20 is kept at a low ambient temperature, the enclosure temperature will fall down in accordance with the ambient temperature.

The status judging unit 22 changes a target voltage value to a new one on the basis of the electric signal indicative of the enclosure temperature, supplied from the thermo-sensor 21. The status judging unit 22 compares the voltage value of the battery 9, supplied from the battery voltage monitoring circuit 7, with the new target voltage value set according to the enclosure temperature of the data transmitter 20 to determine an upper limit of the data transmission bit rate. That is, if the battery voltage value supplied from the battery voltage monitoring circuit 7 is lower than the new target voltage value, the status judging unit 22 lowers the upper limit of the data transmission bit rate. On the contrary, if the battery voltage value is higher than the new target voltage value, the status judging unit 22 raises the data transmission bit rate. Thus, the status judging unit 22 supplies the data processing control circuit 3 with a signal indicative of the determined data transmission bit rate upper limit. However, the status judging unit 22 has set therein a maximum upper limit which will not shorten the service hour of the battery 9 even if the upper limit of the transmission bit rate is thus raised.

In the data transmitter 20 constructed as having been described in the foregoing, data supplied from the data processor 11 will be transmitted wirelessly through a series of steps as shown in the flow chart in FIG. 4.

First at step S16 shown in FIG. 4, the battery voltage monitoring circuit 7 detects a source voltage of the battery 9, converts it to an electric signal, and supplies it to the status judging unit 8.

At step S17, the thermo-sensor 21 detects the enclosure temperature of the data transmitter 20, converts the detected enclosure temperature to an electric signal and supplies it to the status judging unit 22. The status judging unit 22 changes a target voltage value to a new one on the basis of the electric signal indicative of the enclosure temperature, supplied from the thermo-sensor 21.

At step S18, the status judging unit 22 judges whether a voltage value indicated by the electric signal supplied from the battery voltage monitoring circuit 7 is lower than a pre-stored target voltage value. If the voltage value indicated by the electric signal is judged to be lower than the new target voltage value, the status judging unit 22 goes to step S19 where it will lower the upper limit of the data transmission bit rate. On the contrary, if the voltage value indicated by the electric signal is judged to be higher than the new target voltage value, the status judging unit 22 goes to step S20 where it will raise the upper limit of the data transmission bit rate and data will be transmitted at the bit rate. At this time, if the upper limit of the transmission bit rate is already at the maximum, the transmission bit rate is held unchanged.

At step S21, the data processing control circuit 3 requests, via the input/output circuit 2, the data processor 11 for sending a new packetized data.

At step S22, the data processor 11 provides a packetized data to the data processing control circuit 3 via the input/output circuit 2.

At step S23, the data processing control circuit 3 determines a data transmission bit rate, informs the baseband signal processing circuit 12 of the determined data transmission bit rate, and provides the packetized data to the baseband signal processing circuit 12.

Next at step S24, the output control circuit 13 is supplied with a signal indicative of the data transmission bit rate supplied from the data processing control circuit 3.

At step S25, the output control circuit 13 judges whether the data transmission bit rate indicated by the signal is higher or lower than a threshold. If the momentary transmission bit rate is judged as being higher than the threshold, the output control circuit 13 supplies, at step S26, the signal amplifier 6 with a signal for changing the output power correspondingly to the transmission bit rate for transmission data. On the contrary, if the transmission bit rate for data to be transmitted from the data processing control circuit 3 is lower than the threshold, the output control circuit 13 provides, at step S27, a signal which shifts the signal amplifier 6 to a power-saving status in which the signal amplifier 6 will be bypassed or supplied with no power.

Next at step S28, the baseband signal processing circuit 12 produces a baseband signal from the packetized data.

Next at step S29, the baseband signal processing circuit 12 supplies the RF signal modulation circuit 5 with the baseband signal produced from the data supplied from the data processing control circuit 3.

At step S30, the RF signal modulation circuit 5 modulates the baseband signal supplied from the baseband processing circuit 12 to an RF signal which will be transmitted on a carrier wave, and supplies it to the signal amplifier 6.

At step S31, the signal amplifier 6 amplifies the RF signal supplied from the RF signal modulation circuit 5, and wirelessly transmits the amplified RF signal via the antenna 10.

As in the foregoing, in the data transmitter 20, the thermo-sensor 21 detects the enclosure temperature, and a new target voltage value is determined according to the detected enclosure temperature. In the data transmitter 20, if the source voltage of the battery 9 is lower than the new target voltage value, the upper limit of the transmission bit rate is lowered. That is, in the data transmitter 20, when the remaining potential of the battery 9 is lower than a certain value, the upper limit of the data transmission bit rate is controlled to save the battery power. Also, when the ambient temperature falls, the internal resistance of the battery 9 is increased, and thus the battery characteristic will be degraded. Even in this case, in the data transmitter 20, the upper limit of the data transmission bit rate can be controlled correspondingly to the voltage of the battery to prevent the quality of the data communications from becoming lower.

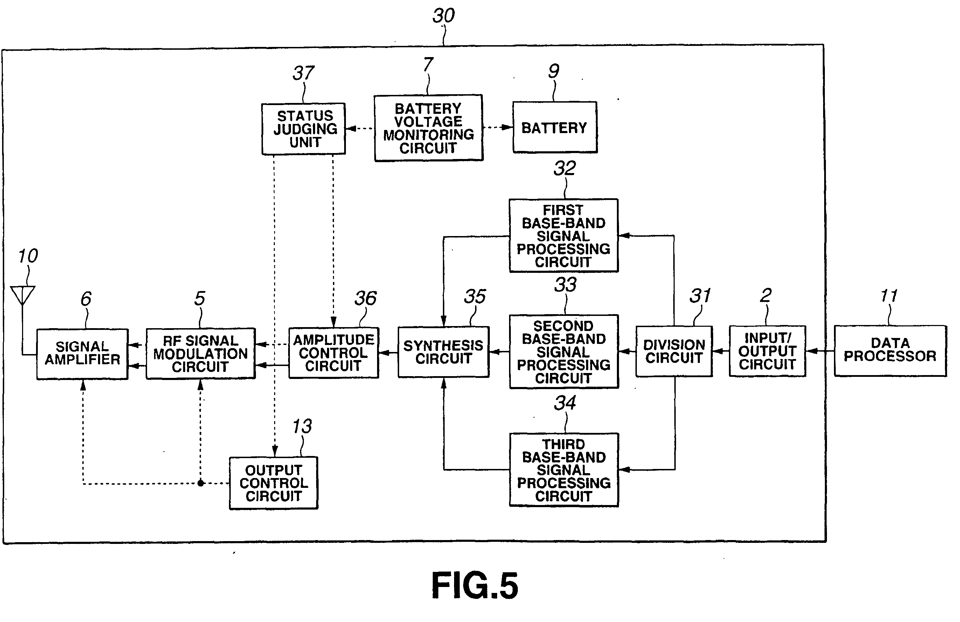

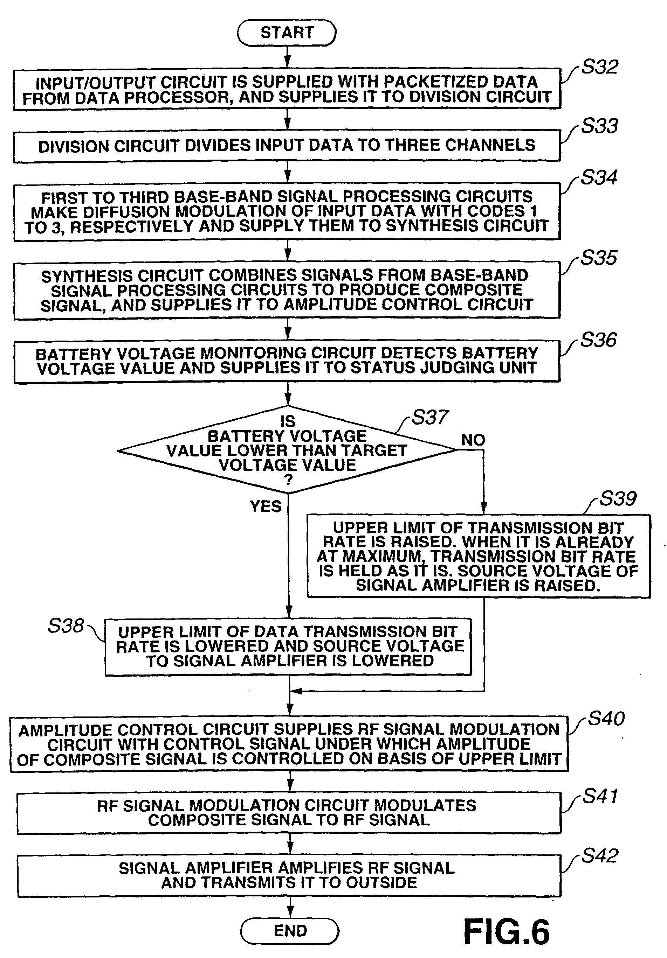

Next, the third embodiment of the data transmitter according to the present invention will be described with reference to FIGS. 5 and 6.

As shown in FIG. 5, the data transmitter according to the third embodiment is generally indicated with a reference 30. The data transmitter 30 is basically similar in construction to the data transmitter 1 according to the first embodiment of the present invention, having been described in the above with reference to FIG. 1, except that it includes a division circuit 31 to divide data, first to third baseband signal processing circuits 32 to 34 to convert the divided data from the division circuit 31 to baseband signals, and a synthesis circuit 35 to combine the baseband signals from the baseband signal processing circuits 32 to 34, respectively, to provide a single composite signal and that the data processing control circuit 36 controls the maximum amplitude of the composite signal. This embodiment is an example of the data transmitter adopting a so-called multi-code CDMA system in which a plurality (three in this embodiment) of code channels for a high speed data transmission. Note that the same or similar elements included in the data transmitter 30 as or to those in the data transmitter 1 are indicated in FIG. 5 with the same or similar references as or to those in FIG. 1, and will not be described in detail below. Note that the solid lines in FIG. 5 indicate the flow of data while the broken lines indicate the flow of control signal.

The data transmitter 30 includes the input/output circuit 2, the RF signal modulation circuit 5, the signal amplifier 6, the battery voltage monitoring circuit 7, the battery 9, the antenna 10, the output control circuit 13, the division circuit 31, first to third baseband signal processing circuits 32 to 34, the synthesis circuit 35, the amplitude control circuit 36, and a status judging unit 37.

The division circuit 31 divides packetized data supplied from the input/output circuit 2 into three channels for example, supplies them to the first to third baseband signal processing circuits 32 to 34, respectively, in which they will be subjected to diffusion modulation with, for example, codes 1 to 3, respectively, being diffusion codes different from each other. The three diffusion-modulated channel signals are supplied to the synthesis circuit 35 which will further be described later.

The synthesis circuit 35 combines the three signals from the baseband signal processing circuits 32 to 34 to produce a composite signal which will be supplied to the amplitude control circuit 36.

The amplitude control circuit 36 is supplied with a control signal from the status judging unit 37 which will further be described later, and controls, based on the control signal, the maximum amplitude of the composite signal supplied from the synthesis circuit 35. Namely, it limits the amplitude.

The status judging unit 37 compares a detected voltage value indicated by an electric signal supplied from the battery voltage monitoring circuit 7 with a pre-stored target voltage value to determine a maximum amplitude of the composite signal. That is, when the detected voltage value supplied from the battery voltage monitoring circuit 7 is lower than the target voltage value, the status judging unit 37 lowers the upper limit of the maximum amplitude of the composite signal. When the detected voltage value supplied from the battery voltage monitoring circuit 7 is higher than the target voltage value, the status judging unit 37 raises the upper limit of the maximum amplitude of the composite signal. Thus, the status judging unit 37 supplies the amplitude control circuit 36 with a control signal indicative of the determined upper limit value.

However, the status judging unit 37 has set therein such an upper limit of the maximum amplitude of the composite signal as will not shorten the service hour of the battery 9 even if the amplitude of the composite signal is raised. Further, the status judging unit 37 has also set therein such a lower limit of the maximum amplitude of the composite signal as will not impair the quality of data communications even if the amplitude of the composite signal is lowered. The maximum amplitude of the composite signal is changed within the above range according to the current status.

In the data transmitter 30 constructed as having been described in the foregoing, data supplied from the data processor 11 will be transmitted wirelessly through a series of steps as shown in the flow chart in FIG. 6.

Fist at step S32 in FIG. 6, the input/output circuit 2 is supplied with packetized data from the data processor 11, and supplies it to the division circuit 31.

At step S33, the division circuit 31 divides the packetized data supplied from the input/output circuit 2 into three channels, supplies them to the first to third baseband signal processing circuits 32 to 34, respectively.

At step S34, the baseband signal processing units 32 to 34 make diffusion modulation of the input data with diffusion codes 1 to 3 different from each other, and supply the diffusion-modulated channel signals to the synthesis circuit 35.

At step S35, the synthesis circuit 35 combines the signals from the baseband signal processing circuits 32 to 34 to produce a composite signal, and supplies it to the amplitude control circuit 36.

First at step S36, the battery voltage monitoring circuit 7 detects a source voltage of the battery 9, converts it to an electric signal, and supplies it to the status judging unit 37.

At step S37, the status judging unit 37 judges whether a voltage value indicated by the electric signal supplied from the battery voltage monitoring circuit 7 is lower than the pre-stored target voltage value. If the detected voltage value indicated by the electric signal is judged as being lower than the target voltage value, the status judging unit 37 goes to step S38 where it will lower the upper limit of the maximum amplitude of the composite signal and the source voltage of the signal amplifier 6. On the contrary, if the detected voltage value is judged to be higher than the target voltage value, the status judging unit 37 goes to step S39 where it will raise the upper limit of the maximum amplitude of the composite signal and source voltage of the signal amplifier 6. Thus, the status judging unit 37 determines an upper limit, and supplies a control signal indicative of the upper limit to the amplitude control circuit 36. At this time, if the upper limit of the maximum amplitude of the composite signal and source voltage of the signal amplifier 6 are already at the maximum, they are held unchanged.

At step S40, the amplitude control circuit 36 is supplied with a control signal indicative of the upper limit of the maximum amplitude of the composite signal, having been determined by the status judging unit 37. The amplitude control circuit 36 limits the amplitude of the composite signal on the basis of the control signal, and supplies the composite signal to the RF signal modulation circuit 5.

At step S41, the RF signal modulation circuit 5 modulates the composite signal supplied from the amplitude control circuit 36 to an RF signal which will be transmitted on a carrier wave, and supplies it to the signal amplifier 6.

At step S42, the signal amplifier 6 amplifies the RF signal supplied from the RF signal modulation circuit 5, and wirelessly transmits the amplified RF signal via the antenna 10.

As in the foregoing, in the data transmitter 30, when the detected source voltage of the battery 9 is lower than the preset target voltage value, a signal for controlling the upper limit of the maximum amplitude of the composite signal is supplied to the amplitude control circuit 36. Also, in the data transmitter 30, when the source voltage of the battery 9 falls, the upper limit of the maximum amplitude of the composite signal is lowered. That is, in the data transmitter 30, if the remaining potential of the battery 9 is lower than a certain value, the upper limit of the maximum amplitude of the composite signal is controlled to reduce the power consumption. Thus, in the data transmitter 30, when the remaining battery potential falls, the power consumption can be reduced by controlling the upper limit of the maximum amplitude of the composite signal to prevent data communications from suddenly being discontinued and the maximum amplitude of the composite signal can be selected correspondingly to the remaining battery potential to prevent the quality of communications from being lower.

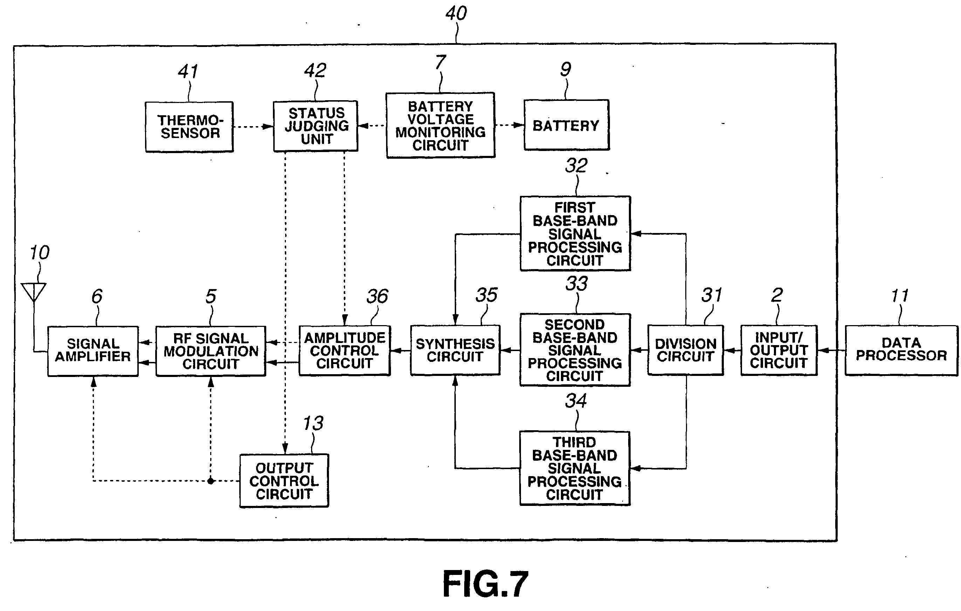

Next, the fourth embodiment of the data transmitter according to the present invention will be described with reference to FIG. 7. As shown, the data transmitter is generally indicated with a reference 40. The data transmitter 40 is basically similar in construction to the data transmitter 30 according to the third embodiment of the present invention, having been described in the above with reference to FIG. 5, except that there is provided a thermo-sensor 41 to detect the temperature of an enclosure of the data transmitter 40. Therefore, the same or similar elements included in the data transmitter 40 as or to those in the data transmitter 30 are indicated in FIG. 5 with the same or similar references as or to those in FIG. 5, and will not be described in detail below. Note that the solid lines in FIG. 7 indicate the flow of data while the broken lines indicate the flow of control signal.

As shown in FIG. 7, the data transmitter 40 includes the input/output circuit 2, the RF signal modulation circuit 5, the signal amplifier 6, the battery voltage monitoring circuit 7, the battery 9, the antenna 10, the output control circuit 13, the division circuit 31, the first to third baseband signal processing circuits 32 to 34, the synthesis circuit 35, the amplitude control circuit 36, the thermo-sensor 41 and a status judging unit 42.

The thermo-sensor 41 is provided to detect the enclosure temperature of the data transmitter 40, converts the detected enclosure temperature to an electric signal and supplies it to the status judging unit 42 which will further be described later. The enclosure temperature of the data transmitter 40 is a temperature of the body or enclosure of the data transmitter 40, which changes under the influence of the ambient temperature. For example, when the data transmitter 40 is kept at a low ambient temperature, the enclosure temperature will fall down in accordance with the ambient temperature.

The status judging unit 42 changes a target voltage value to a new one on the basis of the electric signal indicative of the enclosure temperature, supplied from the thermo-sensor 41. The status judging unit 42 compares the voltage value of the battery 9, supplied from the battery voltage monitoring circuit 7, with the new target voltage value set according to the enclosure temperature of the data transmitter 40 to determine an upper limit of the maximum amplitude of the composite signal. That is, when the voltage value supplied from the battery voltage monitoring circuit 7 is lower than the new target voltage value, the status judging unit 42 lowers the upper limit of the maximum amplitude of the composite signal. When the voltage value supplied from the battery voltage monitoring circuit 7 is higher than the new target voltage value, the status judging unit 42 raises the upper limit of the maximum amplitude of the composite signal. Thus, the status judging unit 42 supplies the amplitude control circuit 36 with a control signal indicative of the determined upper limit value.

However, the status judging unit 42 has set therein such an upper limit of the maximum amplitude of the composite signal as will not shorten the service hour of the battery 9 even if the amplitude of the composite signal is raised. Further, the status judging unit 42 has also set therein such a lower limit of the maximum amplitude of the composite signal as will not impair the quality of data communications even if the amplitude of the composite signal is lowered. The maximum amplitude of the composite signal is changed within the above range according to the current status.

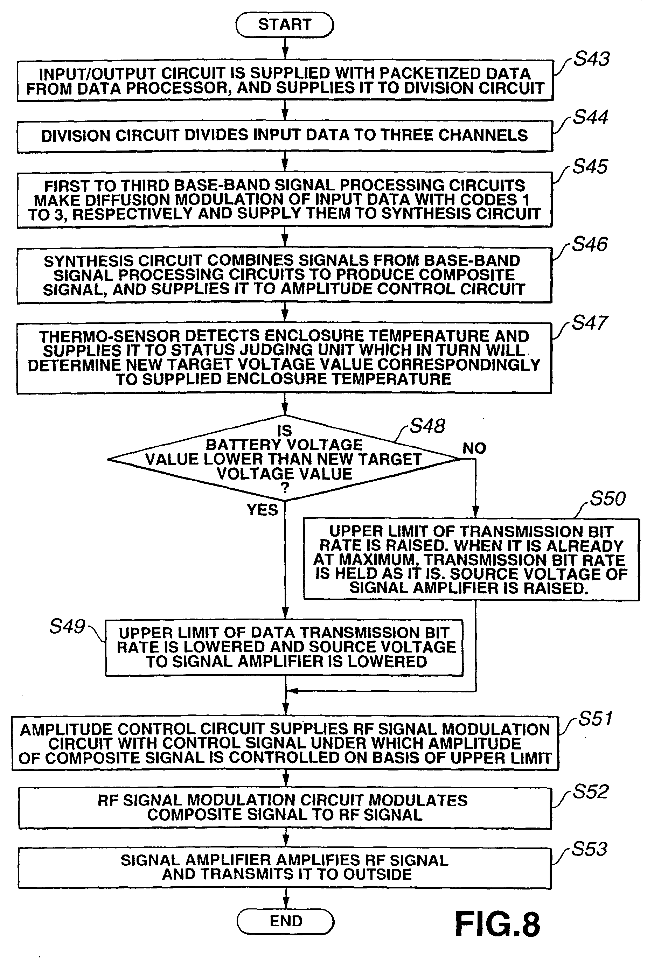

In the data transmitter 40 constructed as having been described in the foregoing, data supplied from the data processor 11 will be transmitted wirelessly through a series of steps as shown in the flow chart in FIG. 8.

First at step S43 in FIG. 8, the input/output circuit 2 is supplied with packetized data from the data processor 11, and supplies it to the division circuit 31.

At step S44, the division circuit 31 divides the packetized data supplied from the input/output circuit 2 into three channels, supplies them to the first to third baseband signal processing circuits 32 to 34, respectively.

At step S45, the baseband signal processing units 32 to 34 make diffusion modulation of the input data with diffusion codes 1 to 3 different from each other, and supply the diffusion-modulated channel signals to the synthesis circuit 35.

At step S46, the synthesis circuit 35 combines the signals from the baseband signal processing circuits 32 to 34 to produce a composite signal, and supplies it to the amplitude control circuit 36.

At step S47, the thermo-sensor 41 detects the enclosure temperature of the data transmitter 40, converts the detected enclosure temperature to an electric signal, and supplies it to the status judging unit 42. The status judging unit 42 changes the target voltage value to a new one on the basis of the electric signal indicative of the enclosure temperature value supplied from the therm-sensor 21.

At step S48, the status judging unit 42 judges whether a voltage value indicated by the electric signal supplied from the battery voltage monitoring circuit 7 is lower the new target voltage value. If the detected voltage value indicated by the electric signal is judged as being lower than the new target voltage value, the status judging unit 42 goes to step S49 where it will lower the upper limit of the maximum amplitude of the composite signal and the source voltage of the signal amplifier 6. On the contrary, if the detected voltage value is judged to be higher than the target voltage value, the status judging unit 42 goes to step S50 where it will raise the upper limit of the maximum amplitude of the composite signal and source voltage of the signal amplifier 6. Thus, the status judging unit 42 determines an upper limit, and supplies a control signal indicative of the upper limit to the amplitude control circuit 36. At this time, if the upper limit of the maximum amplitude of the composite signal and source voltage of the signal amplifier 6 are already at the maximum, they are held as they are.

At step S51, the amplitude control circuit 36 is supplied with the control signal indicative of the upper limit of the maximum amplitude of the. composite signal, having been determined by the status judging unit 42. The amplitude control circuit 36 limits the amplitude of the composite signal on the basis of the control signal, and supplies the composite signal to the RF signal modulation circuit 5.

At step S52, the RF signal modulation circuit 5 modulates the baseband signal supplied from the amplitude control circuit 36 to an RF signal which will be transmitted on a carrier wave, and supplies it to the signal amplifier 6.

At step S53, the signal amplifier 6 amplifies the RF signal supplied from the RF signal modulation circuit 5, and wirelessly transmits the amplified RF signal via the antenna 10.

As in the foregoing, in the data transmitter 40, the enclosure temperature is detected by the thermo-sensor 41 and a new target voltage value is determined correspondingly to the detected enclosure temperature. Thus, in the data transmitter 40, when the detected source voltage of the battery 9 is lower than the new target voltage value, a signal for controlling the upper limit of the maximum amplitude of the composite signal is supplied to the amplitude control circuit 36. Thus, in the data transmitter 40, when the source voltage of the battery 9 falls, the upper limit of the maximum amplitude of the composite signal is lowered.

That is, in the data transmitter 40, if the remaining potential of the battery 9 is lower than a certain value, the upper limit of the maximum amplitude of the composite signal is controlled to reduce the power consumption. Also, in the data transmitter 30, if the ambient temperature falls and thus the internal resistance of the battery 9 is lower so that the characteristic of the battery 9 is degraded, the upper limit of the maximum amplitude of the composite signal can be controlled to prevent the quality of communications from being lower.

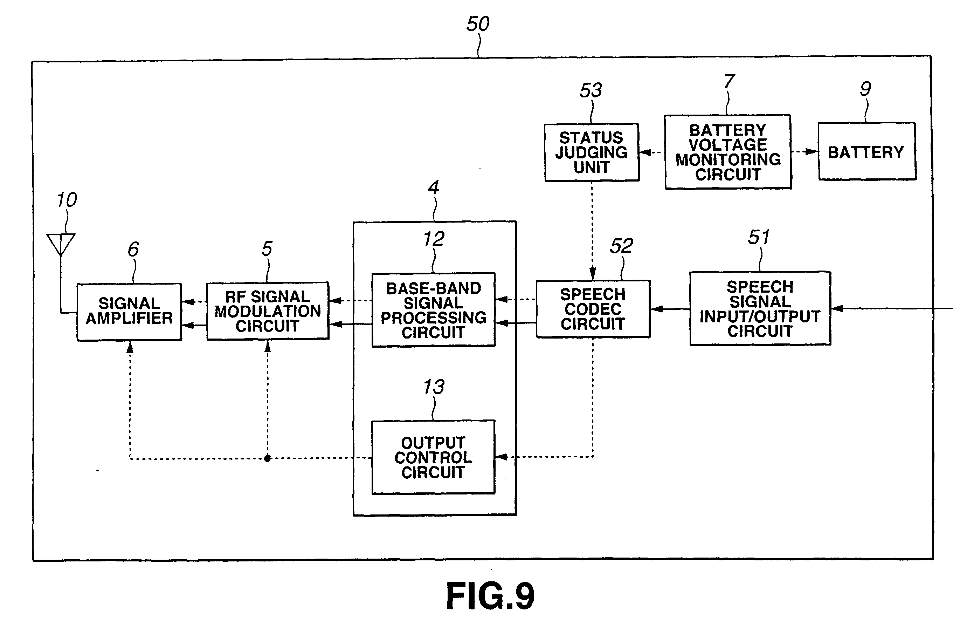

Next, the fifth embodiment of the data transmitter according to the present invention will be described with reference to FIG. 9. As shown in FIG. 9, the data transmitter according to the fifth embodiment is generally indicated with a reference 50. The data transmitter 50 is basically similar in construction to the data transmitter 1 according to the first embodiment of the present invention, having been described in the above with reference to FIG. 1, except that there are provided a speech signal input/output circuit 51 and speech codec (coder/decoder) circuit 52. Therefore, the same or similar elements included in the data transmitter 50 as or to those in the data transmitter 1 are indicated in FIG. 9 with the same or similar references as or to those in FIG. 1, and will not be described in detail below. Note that the solid lines in FIG. 9 indicate the flow of data while the broken lines indicate the flow of control signal.

As shown in FIG. 9, the data transmitter 50 includes the baseband signal processor 4, the RF signal modulation circuit 5, the signal amplifier 6, the battery voltage monitoring circuit 7, the battery 9, the antenna 10, the speech signal input/output circuit 51, the speech codec circuit 52 and a status judging unit 53.

The speech signal input/output circuit 51 is supplied with a speech signal from outside, and supplies it to the speech codec circuit 52 which will further be described later.

The speech codec circuit 52 encodes the speech signal supplied from the speech signal input/output circuit 51, and supplies the encoded speech data to the baseband signal processing circuit 12.

The status judging unit 53 compares a detected voltage value indicated by an electric signal supplied from the battery voltage monitoring circuit 7 with a pre-stored target voltage value to determine an upper limit of an encoding bit rate in the speech codec circuit 52. That is, if the detected voltage value indicated by the electric signal supplied from the battery voltage monitoring circuit 7 is lower than the pre-stored target voltage value, the status judging unit 53 lowers the upper limit of the encoding bit rate. On the contrary, if the detected voltage value is higher than the encoding bit rate upper limit, the status judging unit 53 raises the upper limit. Thus, the status judging unit 53 determines an upper limit and supplies a control signal indicative of the determined upper limit to the speech codec circuit 52. However, the status judging unit 53 has set therein a maximum upper limit which will not shorten the service hour of the battery 9 even if the upper limit of the encoding bit rate is thus raised.

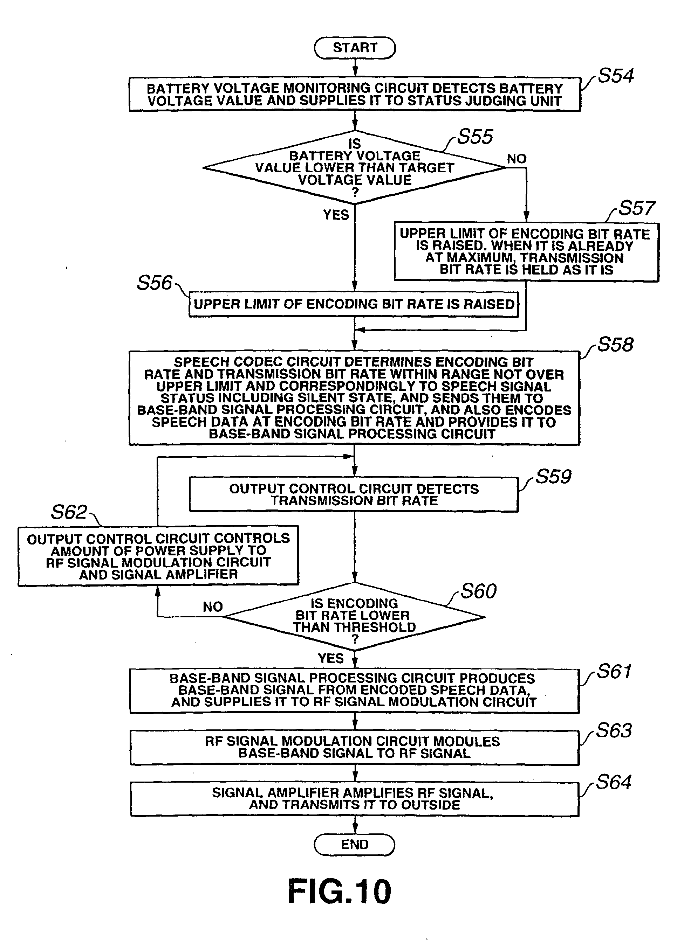

In the data transmitter 50 constructed as having been described in the foregoing, a speech signal supplied from the data processor 11 will be transmitted wirelessly through a series of steps as shown in the flow chart in FIG. 10.

First at step S54 in FIG. 10, the battery voltage monitoring circuit 7 detects a source voltage of the battery 9, converts it to an electric value, and supplies the electric value to the status judging unit 53.

At step S55, the status judging unit 53 judges whether the voltage value indicated by the electric signal supplied from the battery voltage monitoring circuit 7 is lower than the pre-stored target voltage value . When the voltage value indicated by the electric signal is lower than the target voltage value, the status judging unit 53 goes to step S56 where it will lower the upper limit of the data encoding bit rate. On the contrary, if the voltage value indicated by the electric signal is higher than the target voltage value, the status judging unit 53 goes to step S57 where it will raise the upper limit of the data encoding bit rate and transmit data. At this time, if the upper limit of the encoding bit rate is already at the maximum, the encoding bit rate is held unchanged.

At step S58, the speech codec circuit 52 determines, based on the status of a speech signal including a silent state, an encoding bit rate for each frame being an encoding unit within a range in which the upper limit of the data encoding bit rate determined by the status judging unit 53, informs the baseband signal processing circuit 12 of the transmission bit rate corresponding to the encoding bit rate for each frame, encodes the speech data at the encoding bit rate for each frame, and provides the encoded speech data to the baseband signal processing circuit 12.

At step S59, the output control circuit 13 detects the baseband signal transmission bit rate provided from the speech codec circuit 52.

At step S60, the output control circuit 13 detects encoding bit rate information. If it is judged in the speech codec circuit 52 that the speech signal is not in any silent state, the baseband signal processing circuit 12 produces, at step S61, a baseband signal from the encoded speech data on the basis of the transmission bit rate determined at step S58, and supplies it to the RF signal modulation circuit 5. Also, when the transmission bit rate of the transmission data is smaller than a threshold, the output control circuit 13 supplies the signal amplifier 6 with a signal for changing the output power according to the transmission bit rate for the transmission data.

If it is judged in the speech codec circuit 52 that the speech data is in a silent status, the output control circuit 13 controls, at step S62, the amount of power supply to the RF signal modulation circuit 5 and signal amplifier 6. For example, the output control circuit 13 stops the power supply to the RF signal modulation circuit 5 and signal amplifier 6 which will be in dormant state.

At step S63, the RF signal modulation circuit 5 modulates the baseband signal supplied from the baseband signal processing circuit 12 to an RF signal to be transmitted on a carrier wave, and supplies the RF signal to the signal amplifier 6.

At step S64, the signal amplifier 6 amplifies the RF signal supplied from the RF signal modulation circuit 5, and transmits the amplified RF signal via the antenna 10.

As in the foregoing, in the data transmitter 50, when the detected source voltage of the battery 9 is lower than a preset target voltage value, a signal for controlling the encoding bit rate for the speech data is supplied to the speech codec circuit 52. Thus, in the data transmitter 50, when the source voltage of the battery 9 falls, the encoding bit rate for the speech data is lowered. That is, in the data transmitter 50, when the remaining potential of the battery 9 is lower than a certain value, the upper limit of the encoding bit rate for the speech data is controlled to reduce the power consumption. Thus, in the data transmitter 50, it is possible to prevent the data communications from suddenly being discontinued when the remaining potential of the battery 9 falls. Also, even when the battery voltage falls, it is possible to prevent the quality of the data communications from being lower by selecting a data encoding bit rate corresponding to the remaining potential of the battery 9.

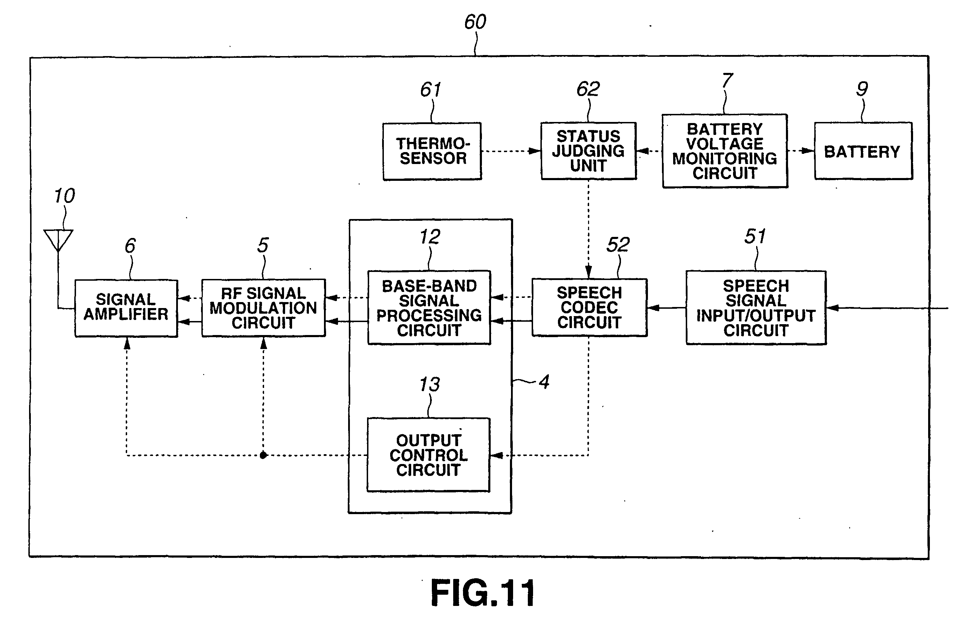

Next, the sixth embodiment of the data transmitter according to the present invention will be described with reference to FIG. 11. As shown in FIG. 11, the data transmitter according to the sixth embodiment is generally indicated with a reference 60. The data transmitter 60 is basically similar in construction to the data transmitter 50 according to the fifth embodiment of the present invention, having been described in the above with reference to FIG. 9, except that there is provided a thermo-sensor 61 for detection of the temperature of an enclosure of the data transmitter 60. Therefore, the same or similar elements included in the data transmitter 60 as or to those in the data transmitter 50 are indicated in FIG. 11 with the same or similar references as or to those in FIG. 9, and will not be described in detail below. Note that the solid lines in FIG. 11 indicate the flow of data while the broken lines indicate the flow of control signal.

As shown in FIG. 11, the data transmitter 60 includes the baseband signal processor 4, the RF signal modulation circuit 5, the signal amplifier 6, the battery voltage monitoring circuit 7, the battery 9, the antenna 10, the speech signal input/output circuit 51, the speech codec circuit 52, the thermo-sensor 61 and a status judging unit 62.

The thermo-sensor 61 is provided to detect the enclosure temperature of the data transmitter 60, converts the detected enclosure temperature to an electric signal and supplies it to the status judging unit 62 which will further be described later. The enclosure temperature of the data transmitter 60 is a temperature of the body of the data transmitter 60, which changes under the influence of the ambient temperature. For example, when the data transmitter 60 is kept at a low ambient temperature, the enclosure temperature will fall down in accordance with the ambient temperature.

The status judging unit 62 changes a target voltage value to a new one on the basis of the electric signal indicative of the enclosure temperature, supplied from the thermo-sensor 61. The status judging unit 62 compares the voltage value of the battery 9, supplied from the battery voltage monitoring circuit 7, with the new target voltage value set according to the enclosure temperature of the data transmitter 60 to determine an upper limit of the encoding bit rate.

That is, when the battery voltage value supplied from the battery voltage monitoring circuit 7 is lower than the new target voltage value, the status judging unit 62 lowers the upper limit of the encoding bit rate. When the battery voltage value supplied from the battery voltage monitoring circuit 7 is higher than the new target voltage value, the status judging unit 62 raises the upper limit of the encoding bit rate. Thus, the status judging unit 62 determines an upper limit and supplies the speech codec circuit 52 with a control signal indicative of the determined upper limit value. However, the status judging unit 62 has set therein a maximum upper limit which will not shorten the service hour of the battery 9 even if the upper limit of the encoding bit rate is thus raised.

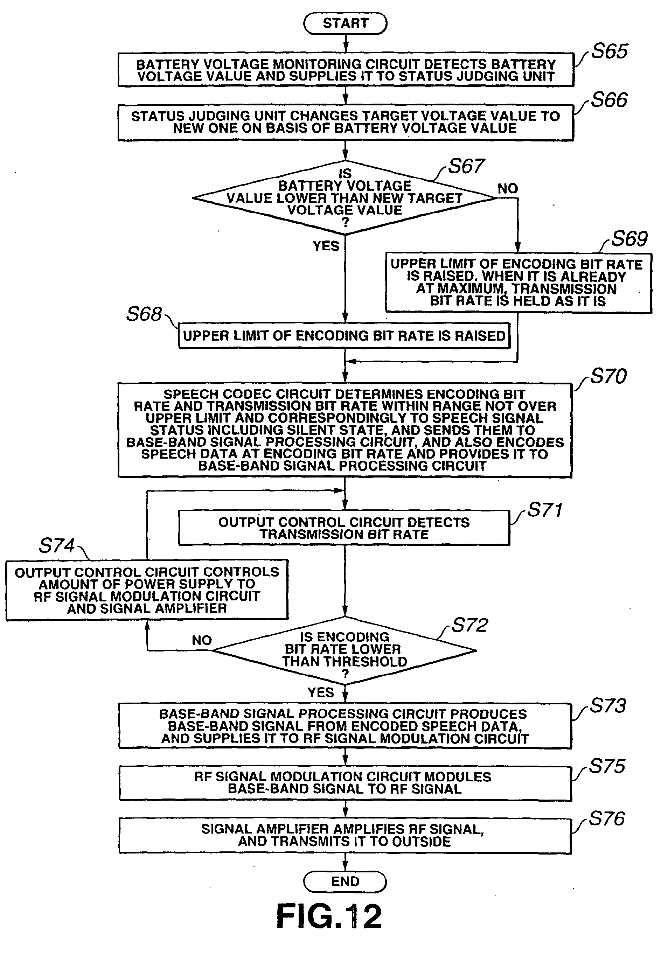

In the data transmitter 60 constructed as having been described in the foregoing, data supplied from the data processor 11 will be transmitted wirelessly through a series of steps as shown in the flow chart in FIG. 12.

First at step S65 in FIG. 12, the battery voltage monitoring circuit 7 detects a source voltage of the battery 9, converts the detected source voltage to an electric signal, and supplies the electric signal to the status judging unit 62.

At step S66, the thermo-sensor 61 detects an enclosure temperature of the data transmitter 60, converts the detected enclosure temperature to an electric signal, and supplies the electric signal to the status judging unit 62. The status judging unit 62 changes the target voltage value to a new one on the basis of the electric signal indicative of the enclosure temperature, supplied from the thermo-sensor 61.

At step S67, the status judging unit 62 judges whether the voltage value indicated by the electric signal supplied from the battery voltage monitoring circuit 7 is lower than the new target voltage value. When the voltage value indicated by the electric signal is lower than the new target voltage value, the status judging unit 62 goes to step S68 where it will lower the upper limit of the speech data encoding bit rate. On the contrary, when the voltage value indicated by the electric signal is higher than the new target voltage value, the status judging unit 62 goes to step S69 where it will raise the upper limit of the speech data encoding bit rate and transmit the data. At this time, if the upper limit of the encoding bit rate is already at the maximum, the encoding bit rate is held unchanged.

At step S70, the speech codec circuit 52 determines, based on the status of a speech signal including a silent state, an encoding bit rate for each frame being an encoding unit within a range in which the upper limit of the data encoding bit rate determined by the status judging unit 62, informs the baseband signal processing circuit 12 of the transmission bit rate corresponding to the encoding bit rate for each frame, encodes the speech data at the encoding bit rate for each frame, and provides the encoded speech data to the baseband signal processing circuit 12.

At step S71, the output control circuit 13 detects the baseband signal transmission bit rate provided from the speech codec circuit 52.

At step S72, the output control circuit 13 detects encoding bit rate information. If it is judged in the speech codec circuit 52 that the speech signal is not in any silent state, the baseband signal processing circuit 12 produces, at step S72, a baseband signal from the encoded speech data on the basis of the transmission bit rate determined at. step S70, and supplies it to the RF signal modulation circuit 5. Also, when the transmission bit rate of the transmission data is smaller than a threshold, the output control circuit 13 supplies the signal amplifier 6 with a signal for changing the output power according to the transmission bit rate for the transmission data.

If it is judged in the speech codec circuit 52 that the speech data is in a silent status, the output control circuit 13 controls, at step S74, the amount of power supply to the RF signal modulation circuit 5 and signal amplifier 6. For example, the output control circuit 13 stops the power supply to the RF signal modulation circuit 5 and signal amplifier 6 which will be in dormant state.

At step S75, the RF signal modulation circuit 5 modulates the baseband signal. supplied from the baseband signal processing circuit 12 to an RF signal which will be transmitted on a carrier wave, and supplies the RF signal to the signal amplifier 6.

At step S76, the signal amplifier 6 amplifies the RF signal supplied from the RF signal modulation circuit 5, and transmits the amplified RF signal via the antenna 10.

As in the foregoing, in the data transmitter 60, the thermo-sensor 61 detects an enclosure temperature of the data transmitter 60 to determine a new target voltage value correspondingly to the detected enclosure temperature. When the source voltage of the battery 9 is lower than the new target voltage value, the the speech codec circuit 52 is supplied with a signal for controlling the upper limit of the speech data encoding bit rate. Thus, in the data transmitter 60, when the remaining potential of the battery 9 falls, the upper limit of the data encoding bit rate is lowered. That is, in the data transmitter 60, when the remaining potential of the battery 9 is lower than a certain value, the upper limit of the speech data encoding bit rate is controlled to reduce the power consumption. Also, even when the battery voltage falls and thus the characteristic of the battery 9 is degraded, it is possible to prevent the quality of the data communications from being lower by controlling the upper limit of the speech data encoding bit rate.

Note that each of the thermo-sensors used in the second, fourth and sixth embodiments of the data transmitter to detect the enclosure temperature of the data transmitter is provided in a location where it will be least influenced by a heat dissipated from any other circuits provided inside the data transmitter.

As having been described in the foregoing, the portable wireless data transmitter according to the present invention includes data transmission processing controlling means for controlling the transmission rate for data to be transmitted, battery voltage detecting means for detecting the voltage of a battery which supplies a drive voltage, and a transmission status judging means for controlling the data transmission processing controlling means correspondingly to a detected voltage supplied from the battery voltage detecting means.

In the above data transmitter, the voltage of the battery which supplies the drive voltage is detected by the battery voltage detecting means and the data transmission rate controlling means is controlled by the transmission status judging means to control the data transmission rate.

Therefore, in the data transmitter according to the present invention, the power consumption is adjusted by controlling the data transmission correspondingly to the remaining potential of the battery, to thereby operate the data transmitter for a longer time. Also, in the data transmitter according to the present, even when the remaining potential of the battery falls, it is possible to prevent the data communications from suddenly being discontinued by controlling the data transmission correspondingly to the remaining potential of the battery and to prevent the quality of the data communications from being lower by changing the data transmission correspondingly to the remaining potential of the battery.

Further, in the data transmitter according to the present invention, even in case the ambient temperature changes and thus the characteristic of the battery changes, the temperature of the data transmitter itself is detected and the data transmission can be changed correspondingly to prevent the quality of the data communications from being lower.

The portable wireless data transmitter according to the present invention includes a data encoding means, battery voltage detecting means for detecting the voltage of a battery which supplies a drive voltage, and a transmission status judging means for controlling the data encoding controlling means correspondingly to a detected voltage supplied from the battery voltage detecting means.

In the above data transmitter, the voltage of the battery which supplies the drive voltage is detected by the battery voltage detecting means and the data transmission rate controlling means is controlled by the transmission status judging means to control the data encoding.

Therefore, in the data transmitter according to the present invention, the power consumption is adjusted by controlling the data encoding correspondingly to the remaining potential of the battery, to thereby operate the data transmitter for a longer time. Also, in the data transmitter according to the present, even when the remaining potential of the battery falls, it is possible to prevent the data communications from suddenly being discontinued by controlling the data encoding correspondingly to the remaining potential of the battery and to keep the quality of the data communications at a constant level by changing the data encoding correspondingly to the remaining potential of the battery.

Further, in the data transmitter according to the present invention, even in case the ambient temperature changes and thus the characteristic of the battery changes, the temperature of the data transmitter itself is detected and the data encoding can be changed correspondingly to prevent the quality of the data communications from being lower.

In the method for wireless data transmission according to the present invention, a source voltage is detected and data transmission is controlled correspondingly to the detected source voltage.

In the above data transmitting method, the data transmission is controlled correspondingly to the source voltage.

Therefore, in the data transmitting method according to the present invention, the power consumption is adjusted by controlling the data transmission correspondingly to the remaining potential of the battery, to thereby operate the data transmitter for a longer time. Also, in the data transmitting method according to the present, even when the remaining potential of the battery falls, it is possible to prevent the data communications from suddenly being discontinued by controlling the data transmission correspondingly to the remaining potential of the battery and to keep the quality of the data communications at a constant level by changing the data transmission correspondingly to the remaining potential of the battery.

Further, in the data transmitter according to the present invention, even in case the ambient temperature changes and thus the characteristic of the battery changes, the temperature of the data transmitter itself is detected and the data transmission can be changed correspondingly to prevent the quality of the data communications from being lower.

In the method for wireless data transmission according to the present invention, a source voltage is detected and the data encoding is controlled correspondingly to the detected source voltage.

In the above data transmitting method, the data encoding is controlled correspondingly to the source voltage.

Therefore, in the data transmitting method according to the present invention, the power consumption is adjusted by controlling the data transmission correspondingly to the remaining potential of the battery, to thereby effect the data transmission for a longer time. Also, in the data transmitting method according to the present, even when the remaining potential of the battery falls, it is possible to prevent the data communications from suddenly being discontinued by controlling the data encoding correspondingly to the remaining potential of the battery and to minimize the degradation in quality of the data communications by changing the data encoding correspondingly to the remaining potential of the battery.

Further, in the data transmitter according to the present invention, even in case the ambient temperature changes and thus the characteristic of the battery changes, the temperature of the data transmitter itself is detected and the data encoding can be changed correspondingly to prevent the quality of the data communications from being lower.

## Claims

1. A portable wireless data transmitter comprising:
data transmission processing controlling means for controlling a transmission rate for data to be transmitted;
battery voltage detecting means for detecting voltage of a battery which supplies a drive voltage;. and
transmission status judging means for controlling the data transmission process controlling means correspondingly to a detected voltage supplied from the battery voltage detecting means.

2. The apparatus as set forth in claim 1, wherein the data transmission processing controlling means controls the input of the data to the apparatus;
the transmission status judging means compares value of the detected voltage supplied from the battery voltage detecting means with a pre-stored target voltage value; and
the data transmission rate controlling means controls a transmission bit rate for packetized data on the basis of the result of the comparison.

3. The apparatus as set forth in claim 1, wherein:
the data transmission processing controlling means controls the input of the data to the apparatus and comprises temperature detecting means for detecting the temperature of an apparatus enclosure;
the battery voltage detecting means changes target voltage value to a new one on the basis of the temperature data supplied from the temperature detecting means;
the transmission status judging means compares the value of the detected voltage supplied from the battery voltage detecting means with the new target voltage value; and
the data transmission processing controlling means controls the transmission bit rate for packetized data on the basis of the result of the comparison.

4. The apparatus as set forth in claim 1, further comprising:
means for modulating a baseband signal generated from the data to a transmission signal; and
means for amplifying the transmission signal.

5. The apparatus as set forth in claim 1, further comprising:
data dividing means for dividing the data into a plurality of channels;
a plurality of baseband signal processing means for diffusion modulation of the plurality of channels with different diffusion codes; respectively;
combining means for combining the baseband signals to produce a composite signal; and
the data transmission processing controlling means controls the maximumvalue of amplitude of the composite signal.

6. The apparatus as set forth in claim 5, wherein:
the transmission status judging means compares the detected voltage value supplied from the battery voltage detecting means with a pre-stored target voltage value; and
the data transmission processing controlling means controls the maximum value of amplitude of the composite signal on the basis of the result of the comparison.

7. The apparatus as set forth in claim 6, further comprising:
temperature detecting means for detecting the temperature of an enclosure of the apparatus, wherein:
the battery voltage detecting means changes the target voltage value to a new target voltage value on the basis of the temperature data supplied from the temperature detecting means;
the transmission status judging means compares the value of the detected voltage supplied from the battery voltage detecting means with the new target voltage value; and
the data transmission processing controlling means controls the maximum value of amplitude of the composite signal on the basis of the result of the comparison.

8. The apparatus as set forth in claim 6, further comprising:
transmission signal modulating means for modulating the composite signal to the transmission signal; and
signal amplifying means for amplifying the transmission signal.

9. A portable wireless data transmitter comprising:
data encoding means;
battery voltage detecting means for detecting voltage of a battery which supplies a drive voltage; and
transmission status judging means for controlling the data encoding controlling means correspondingly to a detected voltage supplied from the battery voltage detecting means.

10. The apparatus as set forth in claim 9, wherein:
the transmission status judging means compares value of the detected voltage supplied from the battery voltage detecting means with a pre-stored target voltage value; and
the data encoding means controls an encoding bit rate on the basis of the result of the comparison.

11. The apparatus as set forth in claim 9, further comprising temperature detecting means for detecting temperature of an apparatus enclosure, wherein
the battery voltage detecting means changes the target voltage value to a new target voltage value on the basis of temperature data supplied from the temperature detecting means;
the transmission status judging means compares the value of the detected voltage supplied from the battery voltage detecting means with the new target voltage value; and
the data encoding means controls the encoding bit rate on the basis of the result of the comparison.

12. The apparatus as set forth in claim 9, further comprising:
transmission signal modulating means for modulating a baseband signal generated from the data to a transmission signal; and
means for amplifying the transmission signal.

13. A method for wireless data transmission comprising steps of:
detecting a source voltage; and
controlling data transmission processing correspondingly to the detected source voltage.

14. The method as set forth in claim 13, further comprising steps of:
comparing the source voltage with a pre-stored target voltage value; and
controlling a transmission bit rate for packetized data on the basis of the result of the comparison.

15. The method as set forth in claim 14, further comprising steps of:
detecting temperature of an apparatus enclosure;
changing the target voltage value to a new target voltage value on the basis of the detected ambient temperature of the enclosure;
comparing the source voltage with the new target voltage value; and
controlling the transmission bit rate for packetized data on the basis of the result of the comparison.

16. The method as set forth in claim 13, further comprising steps of:
generating a baseband signal from the data;
modulating the baseband signal to a transmission signal; and
amplifying and outputting the transmission signal.

17. The method as set forth in claim 13, further comprising steps of:
dividing the data into a plurality of channels;
making diffusion modulation of the plurality of channels with different diffusion codes, respectively;
combining the baseband signals of each channel diffusion modulated to produce a composite signal;
and
controlling the maximum value of amplitude of the composite signal.

18. The method as set forth in claim 17, further comprising steps of:
comparing the source voltage with a pre-stored target voltage value; and
controlling the maximum value of amplitude of the composite signal on the basis of the result of the comparison.

19. The method as set forth in claim 18, further comprising steps of:
detecting temperature, and changing the target voltage value to the new target voltage value on the basis of the detected temperature; and
comparing the source voltage with the new target voltage value, and controlling the maximum value of amplitude of the composite signal on the basis of the result of the comparison.

20. The method as set forth in claim 17, further comprising steps of:
modulating the composite signal to the transmission signal; and
amplifying and outputting the transmission signal.

21. A method for wireless data transmission comprising steps of:
detecting a source voltage; and
controlling a data encoding processing correspondingly to the detected source voltage.

22. The method as set forth in claim 21, further comprising steps of:
comparing the source voltage with a pre-stored target voltage value; and
controlling a transmission bit rate for packetized data on the basis of the result of the comparison.

23. The method as set forth in claim 22, further comprising steps of:
detecting temperature;
changing the target voltage value to a new target voltage value on the basis of the detected temperature;
comparing the source voltage with the new target voltage value; and
controlling the data encoding processing on the basis of the result of the comparison.

24. The method as set forth in claim 21, further comprising steps of:
generating a baseband signal from the data;
modulating the baseband signal to a transmission signal; and
amplifying and outputting the transmission signal.

1. (Deleted)

2. (Deleted)

3. (Amended) A portable wireless data transmitter, comprising:
data transmission processing controlling means for controlling a transmission rate for data to be transmitted;
battery voltage detecting means for detecting voltage of a battery which supplies a drive voltage;
transmission status judging means for controlling the data transmission processing controlling means correspondingly to the detected voltage supplied from the battery voltage detecting means; and
temperature detecting means for detecting the temperature of an enclosure of the apparatus;
the data transmission processing controlling processing means controlling input of the data;
the battery voltage detecting means changing a pre-stored target voltage value to a new target voltage value on the basis of the temperature data supplied from the temperature detecting means;
the transmission status judging means comparing the detected voltage supplied from the battery voltage detecting means with the new target voltage value; and
the data transmission processing controlling means controlling a transmission bit rate for packetized data on the basis of the result of the comparison.

4. (Deleted)

5. (Amended) A portable wireless data transmitter, comprising:
data transmission processing controlling means for controlling a transmission rate for data to be transmitted;
battery voltage detecting means for detecting voltage of a battery which supplies a drive voltage;
transmission status judging means for controlling the data transmission processing controlling means correspondingly to the detected voltage supplied from the battery voltage detecting means;
data dividing means for dividing the data for transmission over a plurality of channels;
plurality of base-band signal processing means for diffusion modulation of the plurality of channel data with different diffusion codes, respectively; and
combining means for combining the base-band signals to produce a composite signal;
the data transmission processing controlling means controlling maximum amplitude of the composite signal.

6. The apparatus as set forth in claim 5, wherein;
the transmission status judging means compares the detected voltage value supplied from the battery voltage detecting means with a pre-stored target voltage value; and
the data transmission processing controlling means controls the maximum value of amplitude of the composite signal on the basis of the result. of the comparison.

7. The apparatus as set forth in claim 6, further comprising:
temperature detecting means for detecting the temperature of an enclosure of the apparatus, wherein;
the battery voltage detecting means changes the target voltage value to a new target voltage value on the basis of the temperature data supplied from the temperature detecting means;
the transmission status judging means compares the value of the detected voltage supplied from the battery voltage detecting means with the new target voltage value; and
the data transmission processing controlling means controls the maximum value of amplitude of the composite signal on the basis of the result of the comparison.

8. The apparatus as set forth in claim 6, further comprising:
transmission signal modulating means for modulating the composite signal to the transmission signal; and
signal amplifying means for amplifying the transmission signal.

9. (Deleted)

10. (Deleted)

11. (Amended) A portable wireless data transmitter, comprising:
data encoding means;
battery voltage detecting means for detecting voltage of a battery which supplies a drive voltage;
transmission status judging means for controlling the data encoding means correspondingly to the detected voltage supplied from the battery voltage detecting means; and
temperature detecting means for detecting temperature of an apparatus enclosure;
the battery voltage detecting means changing a pre-stored target voltage value to a new target voltage value on the basis of the temperature data supplied from the temperature detecting means;
the transmission status judging means comparing the detected voltage value supplied from the battery voltage detecting means with the new target voltage value; and
the data encoding means controlling an encoding bit rate on the basis of the result of the comparison.

12. (Deleted)

13. (Deleted)

14. (Deleted)

15. Amended) A method for wireless data transmission, comprising steps of:
detecting a source voltage;
detecting the temperature of an enclosure of a portable wireless data transmitter in which the method is adopted, and changing a pre-stored target voltage value to a new target voltage value on the basis of the detected enclosure temperature; and
comparing the source voltage with the new target voltage value, and controlling the transmission bit rate for packetized data on the basis of the result of the comparison.

16. (Deleted)

17. (Amended) The method as set forth in claim 13, further comprising steps of:
detecting a source voltage;
controlling data transmission processing correspondingly to the detected source voltage;
dividing the data for transmission over a plurality of channels;
making diffusion modulation of the plurality of channel data with different diffusion codes, respectively;
combining the base-band signals to produce a composite signal;
and
controlling the maximum value of amplitude of the composite signal.

18. The method as set forth in claim 17, further comprising steps of:
comparing the source voltage with a pre-stored target voltage value; and
controlling the maximum value of amplitude of the composite signal on the basis of the result of the comparison.

19. The method as set forth in claim 18, further comprising steps of:
detecting the temperature, and changing the target voltage value to the new target voltage value on the basis of the detected temperature; and
comparing the source voltage with the new target voltage value, and controlling the maximum value of amplitude of the composite signal on the basis of the result of the comparison.

20. The method as set forth in claim 17, further comprising steps of:
modulating the composite signal to the transmission signal; and
amplifying and outputting the transmission signal.

21. (Deleted)

22. (Deleted)

23. (Amended) A method for wireless data transmission, comprising steps of:
detecting a source voltage;
detecting temperature, and changing a pre-stored target voltage value to a new target voltage value on the basis of the detected temperature; and
comparing the source voltage with the new target voltage value, and controlling data encoding processing on the basis of the result of the comparison.

24. (Deleted)
